# EUROPÄISCHE PATENTSCHRIFT

(11) **EP 2 312 014 B1**
(45) Veröffentlichungstag und Bekanntmachung des Hinweises auf die Patenterteilung: **27.05.2015**
(21) Anmeldenummer: 10187390.9
(22) Anmeldetag: 13.10.2010
(51) Int. Cl.: C23C 16/24, C23C 16/54, C23C 16/44, F16J 15/16, F16J 15/40, B01J 3/02

(54) **Anordnung zur Gasseparation und deren Verwendung**
Assembly for gas separation and its application
Agencement de séparation de gaz et son utilisation

(30) Priorität: 15.10.2009 DE 102009049570
(43) Veröffentlichungstag der Anmeldung: 20.04.2011
(73) Patentinhaber: FHR Anlagenbau GmbH, 01458 Ottendorf-Okrilla (DE)
(72) Erfinder: Kreher, Sascha, 01219 Dresden (DE); Köhler, Lutz, 01445 Radebeul (DE); Reppe, Thomas, 01877 Bischofswerda (DE); Schreier, Sebastian, 02979 Elsterheide (DE)
(74) Vertreter: Lippert, Stachow & Partner

(56) Entgegenhaltungen:
- CH-A3- 683 662
- US-A- 4 723 507
- US-A- 5 130 170
- US-A- 5 919 310

## Beschreibung

Die Erfindung betrifft eine Anordnung zur Gasseparation für Vakuumbeschichtungsanlagen mit mehreren Prozessbereichen, insbesondere bei CVD-Anlagen zur Beschichtung und Dotierung von flachen und/oder bandförmigen Substraten, mit einem das Substrat umschließenden und durch eine Separationskammer verlaufenden flachen Tunnel, in dem zwei Umlenkeinrichtungen zur Führung des Substrates in einem vorgegebenen Abstand zueinander angeordnet sind, derart, dass die Umlenkeinrichtungen den Querschnitt des Tunnels einengen, wobei der Tunnel mit Gaszu- und -ableitungen versehen ist.

Bei der Bearbeitung von flachen und/oder bandförmigen Substraten, die gewöhnlich von Rolle-zu-Rolle erfolgt, müssen oft unterschiedliche Bearbeitungskammern durchlaufen werden, in denen unterschiedliche Prozessgase eingesetzt werden. Dabei kommt es darauf an, eine gute Trennung der Bearbeitungskammern voneinander zu gewährleisten, um ein Verschleppen der Prozessgase zu verhindern, was insbesondere bei stark toxischen Gasen besonders wichtig ist, oder auch dann notwendig ist, wenn Gase mit geringem Anteil an Dotanden eingesetzt werden. Im letzteren Fall muss dafür Sorgt getragen werden, dass überhaupt keine Gasvermischung bzw. Gasverschleppung eintreten kann.

Oft werden dazu Gasvorhänge oder Gasschleusen am Anfang und Ende einer Prozesstrecke verwendet. In der WO 2008/085604 A2 werden beispielsweise derartige Gasschleusen für Rolle-zu-Rölle Systeme beschrieben. Wesentliches Element ist hier ein Segment mit geringem Volumen zwischen zwei benachbarten Kammern mit größerem Volumen. Mittig in das Segment mit geringem Volumen wird Stickstoff eingebracht, so dass dieser in Richtung der beiden anderen Kammern strömt. Eine Vermischung der Gase in den beiden benachbarten Kammern wird somit verhindert.

Eine solche Gasseparation ist jedoch bei der CVD-Abscheidung auf einem bandförmigen Material mit amorphem Silizium in verschiedener Dotierung in insgesamt drei aufeinander folgenden Prozessschritten nicht ausreichend. Der geringe Anteil der jeweils eingesetzten Dotanden in den einzelnen Prozessbereichen führt zu besonders hohen Anforderungen an die Separierung der einzelnen Prozessschritte voneinander.

Die US 4 723 507 A offenbart eine Plasmabearbeitungskammer mit Spülgaszuführungen, einer Wasserstoffzuführung sowie einem zugehörigen Gasauslass und einen Kathodenschirm zwischen zwei Umlenkrollen für ein bandförmiges Substrat. Das bandförmige Substrat wird dabei an den Umlenkrollen vorbei durch einen Tunnel geführt, der zwischen den beiden Umlenkrollen mit einer Wasserstoff-Plasma-Kammer versehen ist. Mit einer Spülgaszuführung unter einer der Umlenkrollen soll das Eindringen eines Dotanden aus einer nachgeordneten Dotierkammer in die Wasserstoff-Plasma-Einrichtung verhindert werden. Mit einer weiteren Spülgaszuführung oberhalb des bandförmigen Substrates soll das Eindringen von Kontaminationen in den oberen Durchgang verhindern.

Die US 5 919 310 A betrifft eine Anordnung mit einer Gasschleuse und Rollen zur Führung eines Substratbandes durch einen Kanal, der mittig zwischen den Rollen mit einem schlitzförmigen Gasvorhang versehen ist.

Aus der US 5 130 170 A geht eine PVD-Anlage mit einer oder mehreren PVD-Vorrichtungen mit Umlenkrollen für das zu beschichtende Band hervor, die dieses um eine Trommel legen, sowie mit Gasschleusen beidseitig der PVD-Vorrichbung, die im Transportkanal für das Band Gasvorhänge ausbilden.

Schließlich geht aus der CH 683 662 A3 eine Durchlaufanlage zur Behandlung eines Metallbandes, sowie ein Kanal hervor, der mit einem Anschluss für eine Vakuumpumpe und einer benachbarten Inertgaszuführung zur Ausbildung einer Gasströmung versehen ist.

Der Erfindung liegt die Aufgabe zugrunde, eine Anordnung zur Gasseparation für Anlagen mit mehreren Prozessbereichen, insbesondere bei CVD-Anlagen zur Beschichtung und Dotierung von flachen und/oder bandförmigen Substraten mit amorphem Silizium zu schaffen, mit der eine besonders gute und sorgfältige Gasseparation gewährleistet wird.

Die der Erfindung zugrunde liegende Aufgabe wird bei einer Anordnung der eingangs genannten Art dadurch gelöst, dass zwischen den Umlenkeinrichtungen und neben diesen jeweils ein Gaseinlass zwischen diesen mittig eine Saugöffnung zur Ausbildung einer von den Gaseinlässen zur mittigen Saugöffnung gerichteten Gasströmung angeordnet sind und wobei das Verhältnis der Leitwerte der jeweils äußeren Tunnelabschnitte zum Leitwert des inneren Tunnelabschnittes kleiner als 1:5 ist.

Durch die Umlenkeinrichtungen wird einerseits ein störungsfreier Substratdurchlauf gewährleistet, so dass andererseits enge Spalte zwischen Substrat und dem Tunnel realisiert werden können.

Weiterhin wird durch die definierte Auflage des Substrates auf den Umlenkeinrichtungen der Strömungswiderstand für vorbeiströmende Gase deutlich erhöht, so dass in Verbindung mit der zwischen den Umlenkeinrichtungen ausgebildeten Gasströmung zwischen dem Tunnelein- und -ausgang eine besonders gute Gasseparation erreicht wird.

Besonders vorteilhaft ist es, wenn die Umlenkeinrichtungen aus sich über die gesamte Breite erstreckenden Rollen bestehen, die in Rollenaufnahmen neben dem Tunnel gelagert sind, derart, dass der Luftspalt zwischen dem Substrat und einer Tunnelwand auf einer Seite des Substrates durch die Rollenaufnahmen verläuft. Dadurch wird eine deutliche Erhöhung des Strömungswiderstandes erreicht.

Der Tunnel zwischen den Umlenkrollen ist bevorzugt geradlinig ausgebildet und die sich an die Umlenkrollen anschließenden äußeren Tunnelabschnitte verlaufen gleichsinnig angewinkelt, z.B. in einem Winkel von ca. 5°, nach oben.

In einer weiteren vorteilhaften Fortführung der Erfindung ist der Abstand der Wände des Tunnels, zumindest im geradlinigen Tunnelabschnitt zwischen den Umlenkrollen, auf wenige Millimeter reduziert.

Um eine gute Regulierung der Gasströmung zwischen den Umlenkrollen zu gewährleisten, sind die Gaseinlässe mit Drosselventilen ausgestattet.

In einer weiteren Fortführung der Erfindung ist die Länge der jeweiligen Tunnelabschnitte sehr viel größer, als die freie mittlere Weglänge des Gases bzw. Gasgemisches innerhalb des Tunnelbereiches.

Die erfindungsgemäße Anordnung eignet sich besonders zur vermischungsfreien Verbindung benachbarter Prozessbereiche von Durchlauf-Prozessanlagen und insbesondere zur vermischungsfreien Verbindung von CVD-Abscheidekammern für die Beschichtung von bandförmigen Substraten mit amorphem Silizium unterschiedlicher Dotierung, insbesondere geringer Dotierung.

Die Erfindung soll nachfolgend an einem Ausführungsbeispiel näher erläutert werden. Die zugehörige Zeichnungsfigur zeigt eine erfindungsgemäße Anordnung zur Gasseparation.

Die Vorrichtung zur Gasseparation besteht aus einer Separationskammer 1, durch die sich ein flacher Tunnel 2 zur Durchführung eines flachen bandförmigen Substrates 3 erstreckt.

Um eine gute Führung des flachen Substrates 3 im Tunnel 2 zu erreichen, sind zwei im Abstand zueinander angeordnete Umlenkeinrichtungen 4, 4' im Tunnel vorgesehen. Diese Umlenkeinrichtungen 4, 4' sind als Rollen ausgebildet, die sich über die gesamte Breite der Substrate 3 erstrecken.

Wie aus der Zeichnungsfigur ersichtlich ist, besteht der Tunnel 2 aus einem geradlinigen inneren Tunnelabschnitt 5 zwischen den Umlenkeinrichtungen 4, 4' und sich jeweils anschließenden äußeren Tunnelabschnitten 6, 6'. Die äußeren Tunnelabschnitte 6, 6' sind gegenüber dem inneren Tunnelabschnitt 5 leicht nach oben angewinkelt, beispielsweise im Winkel von ca. 5°. In Verbindung mit nicht dargestellten Ab- und Aufwickeleinrichtungen für das bandförmige Substrat 3 lässt sich dieses über die Umlenkeinrichtungen 4, 4' spannen. Durch die damit straffe Führung des Substrates 3 kann der Tunnel 2 insbesondere zwischen den Umlenkeinrichtungen 4, 4' dieses besonders eng umschließen. D.h. der Spalt 7, 7' zwischen Substrat 3 und Tunnelwand kann besonders eng ausgelegt werden, ohne dass eine Beschädigung des Substrates 3 befürchtet werden müsste.

Dadurch und in Verbindung mit der nachfolgend beschriebenen Maßnahme kann im Tunnel 2 ein besonders hoher Strömungswiderstand erreicht werden.

Die Umlenkeinrichtungen 4, 4' sind seitlich in der Wand des Tunnels 2 in Rollenaufnahmen 8, 8' geführt und zwar derart, dass die Umlenkeinrichtungen 4, 4' etwas in den Tunnel 2 hineinragen und in Verbindung mit dem aufliegenden Substrat 3 den Tunnel 2 auf einer Substratseite abdichten. Wird nun der Spalt 7 auf der gegenüber liegenden Seite des Substrates 3 besonders eng ausgelegt, führt das zu einer besonders starken Vergrößerung des Strömungswiderstandes im Tunnel 2.

Da damit allein noch keine ausreichende Separation erreichbar ist, sind im inneren Tunnelabschnitt 5 neben den Umlenkeinrichtungen 4, 4' Gaseinlässe 9, 9' vorgesehen und zwischen diesen eine Saugöffnung 10. Die Saugöffnung 10 ist mit einer nicht dargestellten Vakuumpumpe verbunden. Zusätzlich sind die Gaseinlässe 9, 9' über Drosselventile 11, 11' mit einem Vorratsbehälter 12 für ein Separationsgas, z.B. Wasserstoffgas, verbunden.

Auf diese Weise kann im inneren Tunnelabschnitt 5 eine von den Gaseinlässen 9, 9' zur mittigen Saugöffnung 10 gerichtete Gasströmung 13 realisiert werden, mit deren Hilfe in Verbindung mit der beschriebenen Erhöhung des Strömungswiderstandes im Tunnel 2 die gewünschte gute Gasseparation zwischen Tunnelein- und -ausgang 14, 15 erreicht wird, indem das eingelassene Gas durch die Saugöffnung 10 wieder entfernt wird. Die damit erzeugte Gasströmung 13 verhindert bzw. minimiert die ungewollte Strömung eines anderen Gases in die Gegenrichtung.

Durch geeignete Dimensionierung der Strömungsleitwerte in den Bereichen zwischen Gaseinlass 9, 9' und der Außenseite der Separationskammer 1, als auch zwischen Gaseinlass und mittiger Abpumpung kann ferner die Gasein- bzw. -ausströmung in den benachbarten Prozessbereich derart eingestellt werden, dass diese keine Störgröße für den dort stattfindenden Prozess darstellt. Weiterhin muss die Länge der jeweiligen Tunnelabschnitte sehr viel größer sein, als die freie Weglänge der im Tunnel 2 befindlichen Gase.

Die erfindungsgemäße Separationskammer 1 ist zur gasdichten Trennung von unterschiedlichen Prozessbereichen von Vakuumbeschichtungsanlagen, welche im Durchlaufbetrieb arbeiten, besonders geeignet.

Insbesondere können benachbarte CVD-Abscheidekammern für die Beschichtung von bandförmigen Substraten 3 mit amorphem Silizium unterschiedlicher Dotierung und insbesondere mit geringer Dotierung vermischungsfrei miteinander verbunden werden.

### Bezugszeichenliste

- 1: Separationskammer
- 2: Tunnel
- 3: Substrat
- 4, 4': Umlenkeinrichtung
- 5: innerer Tunnelabschnitt
- 6, 6': äußerer Tunnelabschnitt
- 7, 7': Spalt
- 8, 8': Rollenaufnahme
- 9, 9': Gaseinlass
- 10: Saugöffnung
- 11: Drosselventil
- 12: Vorratsbehälter
- 13: Gasströmung
- 14: Tunneleingang
- 15: Tunnelausgang

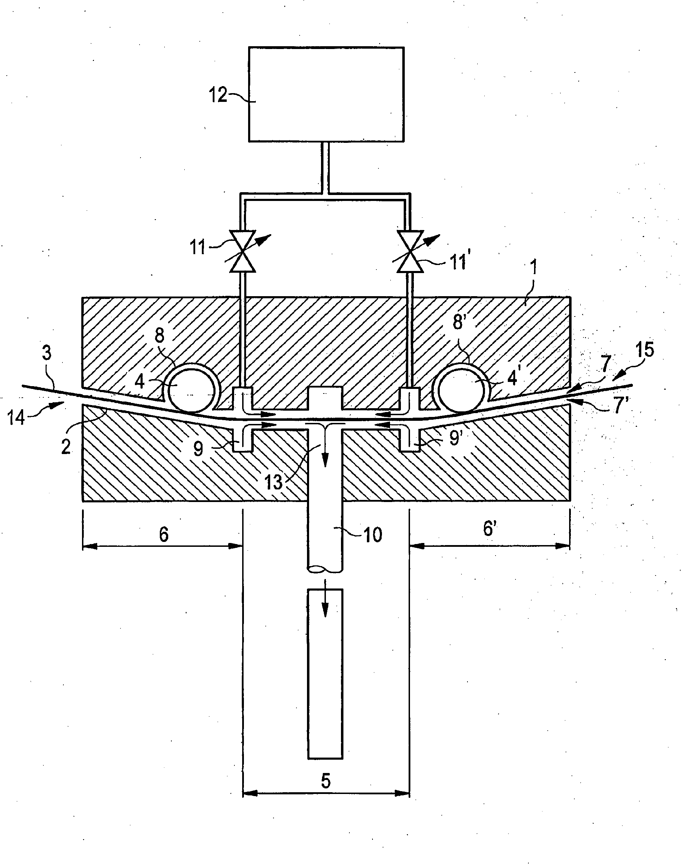

## Patentansprüche

1. Anordnung zur Gasseparation für Vakuumbeschichtungsanlagen mit mehreren Prozessbereichen, insbesondere bei CVD-Anlagen zur Beschichtung und Dotierung von flachen und/oder bandförmigen Substraten, mit einem das Substrat umschließenden und durch eine Separationskammer verlaufenden flachen Tunnel, in dem zwei Umlenkeinrichtungen zur Führung des Substrates in einem vorgegebenen Abstand zueinander angeordnet sind, derart, dass die Umlenkeinrichtungen den Querschnitt des Tunnels einengen, wobei der Tunnel mit Gaszu- und -ableitungen versehen ist, **dadurch gekennzeichnet, dass** zwischen den Umlenkeinrichtungen (4, 4') und neben diesen jeweils ein Gaseinlass (9, 9') zwischen diesen mittig eine Saugöffnung (10) zur Ausbildung einer von den Gaseinlässen zur mittigen Saugöffnung gerichteten Gasströmung (13) angeordnet sind und wobei das Verhältnis der Leitwerte der jeweils äußeren Tunnelabschnitte zum Leitwert des inneren Tunnelanschnitts kleiner als 1:5 ist.

2. Anordnung nach Anspruch 1, **dadurch gekennzeichnet, dass** die Umlenkeinrichtungen (4, 4') aus sich über die gesamte Breite des Substrates (3) erstreckenden Rollen bestehen, die in Rollenaufnahmen (8, 8') neben dem Tunnel (2) gelagert sind, derart, dass der Luftspalt zwischen dem Substrat (3) und einer Tunnelwand auf einer Seite des Substrates (3) durch die Rollenaüfnahme (8, 8') verläuft.

3. Anordnung nach Anspruch 1 und 2, **dadurch gekennzeichnet, dass** der Tunnel (2) zwischen den Umlenkeinrichtungen (4, 4') geradlinig ausgebildet ist und dass die sich an die Umlenkrolleneinrichtungen (4, 4') anschließenden äußeren Tunnelabschnitte (6, 6') gleichsinnig angewinkelt verlaufen.

4. Anordnung nach Anspruch 3, **dadurch gekennzeichnet, dass** der Winkel zwischen dem geradlinigen und den angewinkelten Tunnelabschnitten ca. 5° beträgt.

5. Anordnung nach einem der Ansprüche 1 bis 3, **dadurch gekennzeichnet, dass** der Abstand der Wände des Tunnels (2), zumindest im geradlinigen inneren Tunnelabschnitt (5) zwischen den Umlenkeinrichtungen (4, 4'), auf wenige Millimeter reduziert ist.

6. Anordnung nach Anspruch 5, **dadurch gekennzeichnet, dass** der Abstand ca. 1 mm beträgt.

7. Anordnung nach Anspruch 1, **dadurch gekennzeichnet, dass** die Gaseinlässe (9, 9') mit Drosselventilen (11, 11') ausgestattet sind.

8. Anordnung nach Anspruch 1, **dadurch gekennzeichnet, dass** die Länge der jeweiligen Tunnelabschnitte (5, 6, 6') sehr viel größer ist, als die freie mittlere Weglänge des Gases bzw. Gasgemisches innerhalb des Tunnelabschnittes (5, 6, 6')

9. Verwendung der Anordnung zur Gasseparation nach den Ansprüchen 1 bis 8 zur vermischungsfreien Verbindung benachbarter Prozessbereiche von Durchlauf-Prozessanlagen.

10. Verwendung der Anordnung zur Gasseparation nach den Ansprüchen 1 bis 8 zur vermischungsfreien Verbindung von CVD-Abscheidekammern für die Beschichtung von bandförmigen Substraten mit amorphem Silizium unterschiedlicher Dotierung.

## Claims

1. Assembly for gas separation for vacuum coating plants having a plurality of process regions, in particular in CVD plants for the coating and doping of flat and/or strip-shaped substrates, with a low tunnel which surrounds the substrate and runs through a separation chamber and in which two deflection devices for guiding the substrate are arranged at a stipulated distance from one another in such a way that the deflection devices contract the cross section of the tunnel, the tunnel being provided with gas supply and discharge lines, **characterized in that** between the deflection devices (4, 4') and next to these are arranged in each case a gas inlet (9, 9') and, centrally between the said gas inlets, a suction port (10) for generating a gas flow (13) directed from the gas inlets to the central suction port, and the ratio of the conductances of the in each case outer tunnel sections to the conductance of the inner tunnel section being lower than 1:5.

2. Assembly according to Claim 1, **characterized in that** the deflection devices (4, 4') consist of rollers which extend over the entire width of the substrate (3) and which are mounted in roller receptacles (8, 8') next to the tunnel (2) in such a way that the air gap between the substrate (3) and a tunnel wall on one side of the substrate (3) runs through the roller receptacle (8, 8').

3. Assembly according to Claims 1 and 2, **characterized in that** the tunnel (2) is of rectilinear form between the deflection devices (4, 4'), and **in that** the outer tunnel sections (6, 6') adjacent to the deflection-roller devices (4, 4') run in a codirectionally angled manner.

4. Assembly according to Claim 3, **characterized in that** the angle between the rectilinear and the angled tunnel sections amounts to approximately 5°.

5. Assembly according to one of Claims 1 to 3, **characterized in that** the distance between the walls of the tunnel (2), at least in the rectilinear inner tunnel section (5) between the deflection devices (4, 4'), is reduced to a few millimetres.

6. Assembly according to Claim 5, **characterized in that** the distance amounts to approximately 1 mm.

7. Assembly according to Claim 1, **characterized in that** the gas inlets (9, 9') are equipped with throttle valves (11, 11').

8. Assembly according to Claim 1, **characterized in that** the length of the respective tunnel sections (5, 6, 6') is very much greater than the free average travel length of the gas or gas mixture inside the tunnel section (5, 6, 6').

9. Use of the assembly for gas separation according to Claims 1 to 8 for the intermix-free connection of adjacent process regions of continuous-flow process plants.

10. Use of the assembly for gas separation according to Claims 1 to 8 for the intermix-free connection of CVD deposition chambers for the coating of strip-shaped substrates with amorphous silicon of varying dopage.

## Revendications

1. Ensemble de séparation de gaz pour installations de revêtement sous vide présentant plusieurs zones de traitement, en particulier pour installations de CVD destinées à revêtir et doper des substrats plats et/ou en forme de ruban,
l'ensemble présentant un tunnel plat entourant le substrat et traversant une chambre de séparation et dans lequel deux dispositifs de renvoi qui guident le substrat sont disposés à distance mutuelle prédéterminée de telle sorte que les dispositifs de renvoi rétrécissent la section transversale du tunnel,
le tunnel étant doté de conduits d'amenée et d'évacuation de gaz,
**caractérisé en ce que**
des entrées de gaz (9, 9') avec entre elles une ouverture d'aspiration (10) qui forme un écoulement de gaz (13) orienté des entrées de gaz à l'ouverture centrale d'aspiration sont disposées entre les dispositifs de renvoi (4, 4') et à côté de ceux-ci et
**en ce que** le rapport entre les valeurs directrices des sections extérieures du tunnel et la valeur directrice de la section intérieure du tunnel est inférieur à 1:5.

2. Ensemble selon la revendication 1, **caractérisé en ce que** les dispositifs de renvoi (4, 4') sont constitués de rouleaux qui s'étendent sur toute la largeur du substrat (3) et qui sont montés dans des logements (8, 8') de rouleaux situés à côté du tunnel (2) de telle sorte que l'interstice d'air entre le substrat (3) et une paroi du tunnel sur un côté du substrat (3) s'étende à travers les logements (8, 8') de rouleaux.

3. Ensemble selon les revendications 1 et 2, **caractérisé en ce que** le tunnel (2) est rectiligne entre les dispositifs de renvoi (4, 4') et **en ce que** les sections extérieures (6, 6') du tunnel qui se raccordent aux dispositifs (4, 4') de rouleaux de renvoi sont coudées dans le même sens.

4. Ensemble selon la revendication 3, **caractérisé en ce que** l'angle entre les sections rectilignes et les sections coudées du tunnel est d'environ 5°.

5. Ensemble selon l'une des revendications 1 à 3, **caractérisé en ce que** la distance des parois du tunnel (2), au moins dans la section intérieure rectiligne (5) du tunnel entre les dispositifs de renvoi (4, 4') est réduite à quelques millimètres.

6. Ensemble selon la revendication 5, **caractérisé en ce que** la distance vaut environ 1 mm.

7. Ensemble selon la revendication 1, **caractérisé en ce que** les entrées de gaz (9, 9') sont équipées de soupapes d'étranglement (11, 11').

8. Ensemble selon la revendication 1, **caractérisé en ce que** la longueur des différentes sections (5, 6, 6') du tunnel est beaucoup plus grande que la longueur moyenne libre de parcours du gaz ou du mélange de gaz à l'intérieur de la section (5, 6, 6') du tunnel.

9. Utilisation de l'ensemble de séparation de gaz selon les revendications 1 à 8 pour relier sans mélange des parties voisines de traitement d'installation de traitement en continu.

10. Utilisation de l'ensemble de séparation de gaz selon les revendications 1 à 8 pour relier sans mélange des chambres de dépôt CVD pour le revêtement de substrats en forme de ruban par du silicium amorphe présentant différents dopages.
